# FASCICULE DE BREVET EUROPEEN

(11) **EP 1 970 961 B1**
(45) Date de publication et mention de la délivrance du brevet: **24.04.2013**
(21) Numéro de dépôt: 08102599.1
(22) Date de dépôt: 14.03.2008
(51) Int. Cl.: H01L 27/32, G09G 3/32

(54) **Matrice active d'un écran électroluminescent organique**
Aktive Matrix eines organischen elektrolumineszenten Bildschirms
Active matrix of an organic electroluminescent display

(30) Priorité: 16.03.2007 FR 0701929
(43) Date de publication de la demande: 17.09.2008
(73) Titulaire: THALES, 92200 Neuilly sur Seine (FR)
(72) Inventeur: Kretz, Thierry, 38430 Saint Jean de Moirans (FR); Lebrun, Hugues, 38500 Coublevie (FR); Chuiton, Elisabeth, 38420 Revel (FR)
(74) Mandataire: Esselin, Sophie

(56) Documents cités:
- US-A1- 2004 066 146
- US-A1- 2004 164 303

## Description

La présente invention concerne une matrice active pour écran électroluminescent organique, matrice AMOLED *(Active Matrix Organic Light Emitting Diode),* et plus particulièrement un arrangement des points image dans une telle matrice.

Dans un écran électroluminescent organique, l'élément image (pixel) est une structure à diode électroluminescente organique. Un tel écran ne nécessite pas de source de lumière additionnelle, contrairement à d'autres dispositifs d'affichage tels que les dispositifs dits LCD *(Liquid Crystal Display).* Il a comme autres avantages, de consommer peu, d'avoir une grande brillance, et des coûts de fabrication réduits. Le principe à la base de l'affichage de données vidéo par des diodes OLED est la modulation du courant de la diode. Ceci est obtenu par un transistor de commande en courant, qui reçoit sur sa grille une tension correspondant à la donnée vidéo à afficher et fournit un courant correspondant à la diode. En pratique, l'écran est ainsi constitué de deux substrats, typiquement l'un en verre supportant une matrice active avec les circuits de commande en courant et des électrodes pixels, une diode électroluminescente organique étant constituée sur chaque électrode pixel, entre chaque électrode pixel et un plan de tension de référence, l'autre en verre également scelle la zone contenant les diodes électroluminescentes ainsi que leurs électrodes en les isolant de l'eau et de l'air.

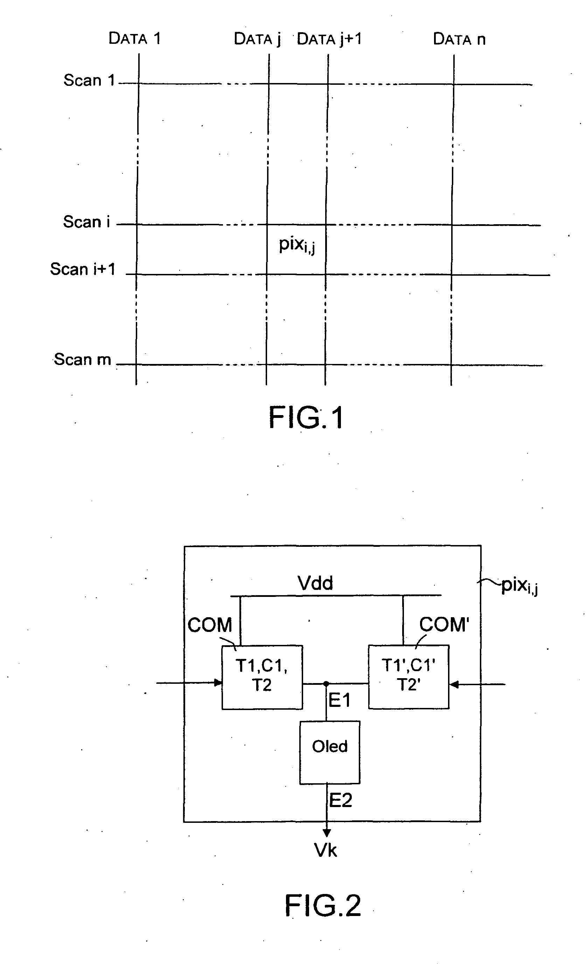

Comme illustré de façon schématique sur la figure 1, une matrice active d'un écran AMOLED comprend habituellement n.m pixels pix_{i,j}, i= 1 à m ; j=1 à n, m lignes de sélection Scan i et n colonnes Data j permettant d'adresser n pixels de l'écran. Par exemple le pixel pix_{i,j} peut être commandé pour afficher une information vidéo, au moyen de la colonne Data j, par laquelle est appliquée une tension correspondant à l'information vidéo à afficher et une ligne de sélection Scan i.

Dans l'invention, on s'intéresse à des structures de commande en courant d'un point image, ou pixel, particulières qui permettent de résoudre un problème connu de dégradation de l'affichage des écrans AMOLEDs dû à la dérive de la tension de seuil des transistors de commande en courant qui pilotent les diodes électroluminescentes organiques.

On connaît de la demande de brevet US publiée sous le numéro US2004/164303A1, une structure qui prévoit une pluralité de transistors de commande en courant connectés et commandés en parallèle pour piloter chaque diode électroluminescente organique, de manière à délivrer un minimum de courant à la diode, indépendamment des variations des caractéristiques de ces transistors.

Dans la présente invention, on s'intéresse à des structures à deux circuits de commande en courant, qui permettent de ménager une phase de récupération de la dérive de la tension de seuil des transistors de commande en courant de chaque pixel. Plus précisément, comme représenté en figure 2, chaque pixel pix_{i,j} comprend une structure à deux circuits de commande COM et COM' pour piloter la diode organique Oled du pixel. Ces deux circuits COM et COM' ont chacun une sortie qui commande une électrode E1 de la diode Oled, qui correspond à l'électrode pixel réalisée sur la matrice active, tandis que l'autre électrode E2 (cathode) de la diode qui correspond à la contre-électrode est reliée à un potentiel Vk commun à tous les pixels.

Les circuits COM et COM' ont une structure identique, comprenant au moins : un transistor de commutation, un transistor de commande en courant et une capacité de maintien. Par convention, on note T1, C1 et T2 ces éléments du premier circuit référencé COM et T1', C1' et T2' ces éléments du deuxième circuit référencé COM'.

On connaît de la demande de brevet US publiée sous le numéro US 2004/066146A1, une structure à deux circuits de commande de structure identique, le deuxième circuit de commande étant un circuit dit de backup, prévu pour se substituer au premier circuit, en cas de défectuosité du premier circuit constatée en sortie de fabrication. Notamment, le deuxième circuit est prévu pour le cas échéant, être commandé par les mêmes lignes d'adressage que le premier circuit. Cette structure ne permet pas de compenser des variations au cours du temps des caractéristiques des transistors de commande en courant.

Dans l'invention, on s'intéresse à une structure de commande qui permet de ménager une phase de compensation. Les circuits COM et COM' sont commandés par des lignes de sélection et/ou de données de la matrice de telle sorte qu'ils aient une fonction différente à chaque trame vidéo, ces fonctions étant inversées périodiquement. Ces fonctions sont : 1.-afficher une information vidéo, par application d'une tension vidéo sur la grille du transistor de commande en courant, pour fournir un courant correspondant à la diode Oled et 2.-compenser le stress occasionné par la première fonction, par application d'une tension de blocage sur la grille du transistor de commande en courant.

Ainsi, pendant une trame vidéo donnée, l'un des deux circuits, par exemple le circuit COM, a la fonction d'afficher l'information vidéo via la diode Oled, par application d'une tension vidéo correspondante sur la grille de son transistor de commande en courant, T2, alors que l'autre circuit, dans l'exemple COM', a la fonction d'appliquer une tension de blocage sur la grille de son transistor de commande en courant, T2', ce qui met ce transistor en phase de récupération de la dérive de tension de seuil.

Les fonctions des deux circuits sont inversées périodiquement, en sorte qu'une trame sur deux en moyenne est mise à profit pour chaque circuit de commande pour destresser son transistor de commande en courant. La dérive moyenne de la tension de seuil de chaque transistor de commande en courant de la matrice active est nulle ou approximativement nulle. Ceci peut être obtenu sans affecter le rapport de cycle d'application de la tension vidéo sur la diode OLED, en sorte que la diode reste commandée en continu (rapport de cycle de 100%).

Pour commander les deux circuits COM et COM' de façon appropriée comme indiqué ci-dessus, des lignes et/ou des colonnes de la matrice sont utilisées, avec le cas échéant des lignes ou colonnes supplémentaires prévues spécialement, suivant la structure des circuits de commande. Plus précisément, dans un premier mode de réalisation, on a une structure de commande à quatre transistors, deux par circuit de commande COM, COM' (un transistor de commutation T1, T1' et un transistor de commande en courant T2, T2'), et des lignes ou des colonnes supplémentaires sont insérées dans la matrice pour les piloter de manière appropriée. Dans un autre mode de réalisation, on a une structure de commande à six transistors, trois par circuit de commande COM, COM' (deux transistors de commutation et un transistor de commande en courant), et des lignes de sélection des pixels précédente et suivante de la matrice sont utilisées en plus de la ligne et de la colonne de sélection habituelles pour piloter les transistors des circuits de commande COM et COM' de manière appropriée.

Un problème technique qui se pose dans l'invention est comment augmenter le nombre de transistors par pixel et/ou le nombre de lignes ou colonnes nécessaires pour commander chaque pixel, tout en obtenant un taux d'ouverture optique pour une taille de pixel (et donc de matrice active) et un rendement de fabrication optimum.

Une solution apportée par l'invention à ce problème technique est un arrangement particulier des éléments de commande du point image et une topologie optimisée de matrice active correspondant à ces structures de commande des points images OLED avec les fonctionnalités souhaitées, et en particulier une topologie d'une matrice active pour écran AMOLED à 4 ou 6 transistors TFT par électrode pixel.

Telle que revendiquée l'invention concerne donc une matrice active pour un écran électroluminescent organique, comprenant des points images arrangés en lignes et en colonnes et des lignes de sélection et des lignes de données pour commander lesdits points image telles que chaque point image est disposé entre deux lignes de sélection de la matrice et chaque ligne de donnée est disposée entre deux colonnes de points image de la matrice, chaque point image comprenant une électrode pixel apte à recevoir une diode électroluminescente organique en surface, et un premier et un deuxième circuits de commande en courant connectés à ladite électrode pixel, avec une structure identique comprenant un transistor de commande en courant connecté entre une tension d'alimentation Vdd et ladite électrode pixel et au moins un premier transistor de commutation pour commander la grille dudit transistor de commande en courant, ledit premier transistor de commutation étant connecté entre une ligne de donnée de la matrice et la grille dudit transistor de commande en courant, et ayant sa grille connectée à une ligne de sélection de la matrice, les électrodes de source ou drain des transistors de commutation et de commande et les électrodes pixel étant réalisées sur un niveau métal source drain, et les électrodes de grille de ces transistors étant chacune réalisées par une ligne de sélection de la matrice, sur un niveau métal de grille, caractérisé en ce que
- pour chaque point image un circuit de commande est disposé entre une première de ces deux lignes de sélection et son électrode pixel, ladite première ligne de sélection formant la grille du premier transistor de commutation de ce circuit de commande, et l'autre circuit de commande est disposé entre une deuxième de ces deux lignes de sélection et l'électrode pixel, ladite deuxième ligne de sélection formant la grille du premier transistor de commutation de ce circuit de commande,
- une électrode source drain des transistors de commande est formée par un bus d'alimentation Vdd réalisé sur le niveau métal source drain, et l'autre électrode source drain des transistors de commande est formée par au moins un doigt qui est une excroissance de l'électrode pixel sur le même niveau métal source drain;
- chaque ligne de données est formée en utilisant ledit niveau de métal source-drain et ledit niveau de métal de grille, ledit niveau de métal de grille étant utilisé le long des électrodes pixel et ledit niveau de métal source drain étant utilisé dans les zones entre lesdites électrodes pixel où sont réalisés les transistors de commutation desdits circuits de commande.

Dans un mode de réalisation, pour une matrice dans laquelle les circuits de commande comprennent un deuxième transistor de commutation connecté entre la ligne de sélection à laquelle est connectée la grille du premier transistor de commutation du circuit de commande considéré, et la grille dudit transistor de commande et dont la grille est connectée à une autre ligne de sélection, chaque ligne de sélection est dédoublée dans la zone active en une première branche et une deuxième branche disposées de part et d'autre d'une rangée correspondante de points image.

L'invention s'applique à des écrans à diodes organiques électroluminescentes comprenant une matrice active selon l'invention.

D'autres avantages et caractéristiques de l'invention sont détaillés dans la description suivante en référence aux dessins illustrés de modes de réalisation de l'invention, donnés à titre d'exemple non limitatif. Dans ces dessins :
- la figure 1 illustre de façon schématique une structure de matrice active OLED selon l'état de l'art;
- la figure 2 est un schéma de principe d'un point image OLED d'une matrice à laquelle s'applique l'invention;
- la figure 3 illustre un schéma électrique équivalent d'une première structure d'élément image à diode OLED; et
- les figures 4 et 5 illustrent une implémentation correspondante selon l'invention;
- la figure 6 illustre un schéma électrique équivalent d'une deuxième structure d'élément image à diode OLED;
- et les figures 7 et 8 illustrent une implémentation correspondante selon l'invention;
- la figure 9 illustre une troisième structure d'élément image à diode OLED selon un autre mode de réalisation selon l'invention; et
- les figures 10 à 12 illustrent une implémentation correspondante selon l'invention; et
- la figure 13 illustre le maillage de la tension Vdd applicable notamment aux figures 3 à 8 et la figure 14 une distribution du Vdd qui s'applique plus particulièrement aux figures 9 à 12.

Dans la description suivante trois structures de commande en courant à deux circuits COM ET COM' sont présentées et pour chaque structure, un arrangement du point image et une implémentation correspondante de la matrice active, suivant l'invention sont expliqués.

Dans un souci de clarté et de simplification de l'exposé, les éléments communs aux différentes figures portent les même références.

On appelle lignes de sélection Scan i ou Scan i' les lignes qui commandent les grilles des transistors de commutation. Le prime signifie que la ligne est prévue dans la matrice en plus de la ligne de sélection habituelle.

On appelle lignes de donnée DATA j ou Data j' les lignes par lesquelles les tensions vidéo ou de blocage sont transmises aux transistors de commutation. Le signe prime signifie que la ligne est prévue dans la matrice en plus de la ligne de donnée habituelle.

On appelle indifféremment électrode source-drain d'un transistor Tk, les deux électrodes de part et d'autre du canal d'un transistor, leurs fonctions étant indifférenciées. Ces deux électrodes sont notées ek_{sd} et ek'_{sd.}

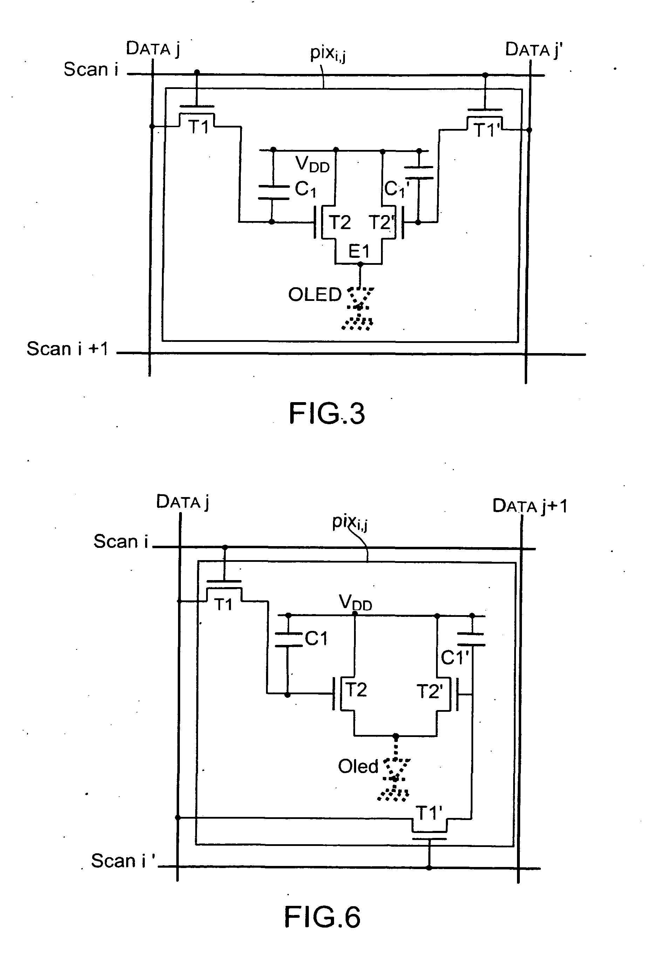

Les figures 3 et 6 sont deux exemples de schéma de connexion électrique d'une structure de commande à quatre transistors, deux par circuit de commande COM, COM'. Dans ce cas, chaque circuit de commande comprend deux transistors, un transistor de commutation T1, T1', et un transistor de commande en courant T2, T2'. Le transistor de commutation (T1, T1') est connecté entre une ligne de donnée et la grille du transistor de commande (T2, T2') et sa grille est connectée à une ligne de sélection, permettant d'appliquer une tension de commande (vidéo ou blocage) sur la grille du transistor de commande (T2, T2') quand le pixel est sélectionné. Le transistor de commande (T2, T2') est connecté en générateur de courant entre une tension d'alimentation Vdd et l'électrode E1 de commande de la diode Oled. La capacité de maintien (C1, C1') est connectée entre la grille du transistor de commande et la tension d'alimentation Vdd. On notera qu'il existe des variantes de connexion de la capacité de maintien. Par exemple, la capacité de maintien de l'un des circuits de commande pourrait être connectée à la ligne de sélection qui commande la grille du transistor de commutation de l'autre circuit de commande (non illustré).

La différence entre les deux structures tient dans la réalisation de l'adressage des transistors de commutation T1 et T1', pour commander de manière alternative la fonction d'affichage ou la fonction de récupération sur les circuits de commande associés COM et COM'.

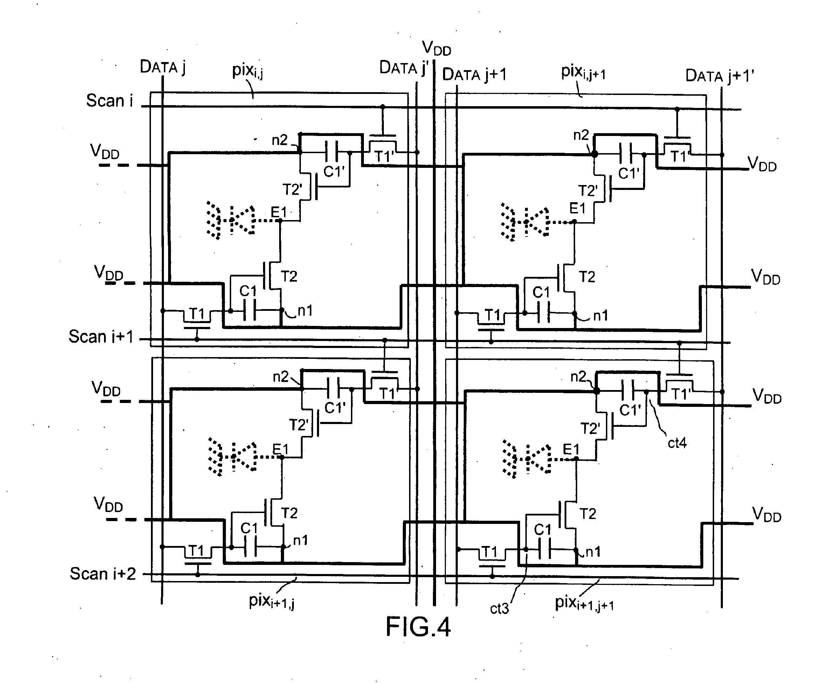

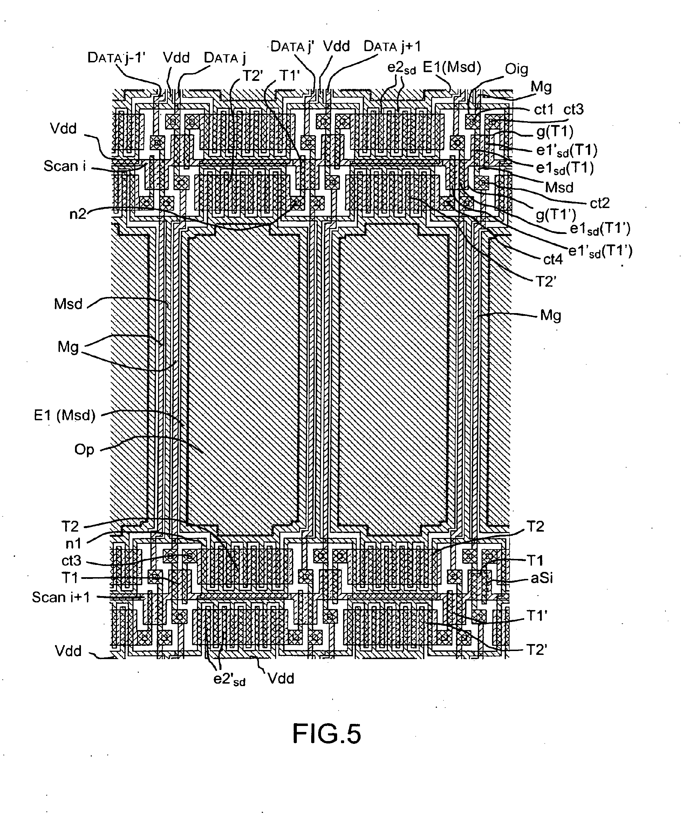

La figure 3 est un schéma électrique de principe qui illustre un premier mode de réalisation de cet adressage. La figure 4 est un schéma électrique correspondant à l'implémentation d'un point image correspondant selon l'invention et la figure 5 montre une implémentation topologique d'une matrice active correspondante.

Dans ce premier mode de réalisation, deux lignes de données par pixel sont prévues, et la commande alternative en affichage vidéo et phase de récupération des deux transistors de commutation d'un point image pix_{i,j} utilise deux lignes de donnée DATA j et DATA j' associées au point image, chaque ligne de donnée recevant alternativement une tension vidéo et une tension de blocage, les grilles des transistors de commutation T1 et T1' étant pilotées par la ligne de sélection Scan i du point image. La première ligne de donnée DATA j est connectée au drain ou à la source du transistor de commutation T1 ; la deuxième ligne de donnée DATA j' est connectée au transistor de commutation T1'. Une matrice correspondante de n colonnes x m rangées de points image nécessite alors 2.n lignes de données, deux par colonne, et m lignes de sélection pour son adressage, soit n colonnes supplémentaires par rapport à une matrice habituelle. Elle comprend par ailleurs deux circuits de commande à 2 transistors chacun par point image.

Dans un arrangement selon l'invention, chaque point image pix_{i,j} est disposé entre deux lignes de sélection Scan i et Scan i+1, comme mis en évidence sur le schéma électrique de la figure 4 et le schéma topologique de la figure 5, avec une disposition symétrique des circuits COM et COM'. Cette disposition est facilitée par une modification de la commande des transistors de commutation T1 et T1' par rapport au schéma de la figure 3 : ces transistors sont commandés par deux lignes de sélection différentes de l'écran, Scan i et Scan i+1, plutôt que par la même ligne. Dans l'exemple, la grille du transistor de commutation T1' est pilotée par la ligne de sélection Scan i ; la grille du transistor de commutation T1 est pilotée par la ligne de sélection Scan i+1.

Cet arrangement présente avantageusement :
- une symétrie de la topologie au sein du point image pix_{i,j} par rapport à l'électrode pixel E1, chaque circuit de commande situé au plus près de la ligne de sélection qui le pilote, dans l'exemple Scan i pour le circuit COM' et Scan i+1 pour le circuit COM ;
- un positionnement symétrique des transistors T2 des points image d'une rangée par rapport aux transistors T2' (et vice versa) des points image de la rangée suivante (ou précédente) relativement à la ligne de sélection entre les deux rangées. Dans l'exemple les transistors T2 sont positionnés au-dessus de chaque ligne de sélection et les transistors T2' positionnés en dessous ;
- une disposition tête-bêche de part et d'autre d'une ligne de sélection du premier transistor de commutation du premier circuit de commande d'un point image avec le premier transistor de commutation d'un deuxième circuit de commande d'un autre point image. On a ainsi des couples de transistors T1, T1' disposés tête bêche par rapport à une ligne de sélection commune qui pilote ces deux transistors T1 et T1', comme par exemple le couple formé par le transistor T1 du point image pix_{i+1,j} et le transistor T1' du point image pix_{i,j+1} comme on peut le voir sur la figure 4, et comme mis en évidence dans la partie en bas à droite du schéma topologique sur la figure 5. Ce positionnement tête-bêche par rapport à une ligne de sélection permet d'optimiser l'espace et donc favorise le taux d'ouverture optique. En effet, les lignes de sélection qui sont réalisées de manière habituelle en métal de grille Mg (typiquement du titane molybdène), ont un dessin adapté (figure 5) pour venir former les grilles g des transistors de commutation T1 et T1'. Et une électrode source de ces transistors est formée par la ligne de données associée, sans avoir à réaliser d'excroissance de cette ligne. L'espace est optimisé au mieux.

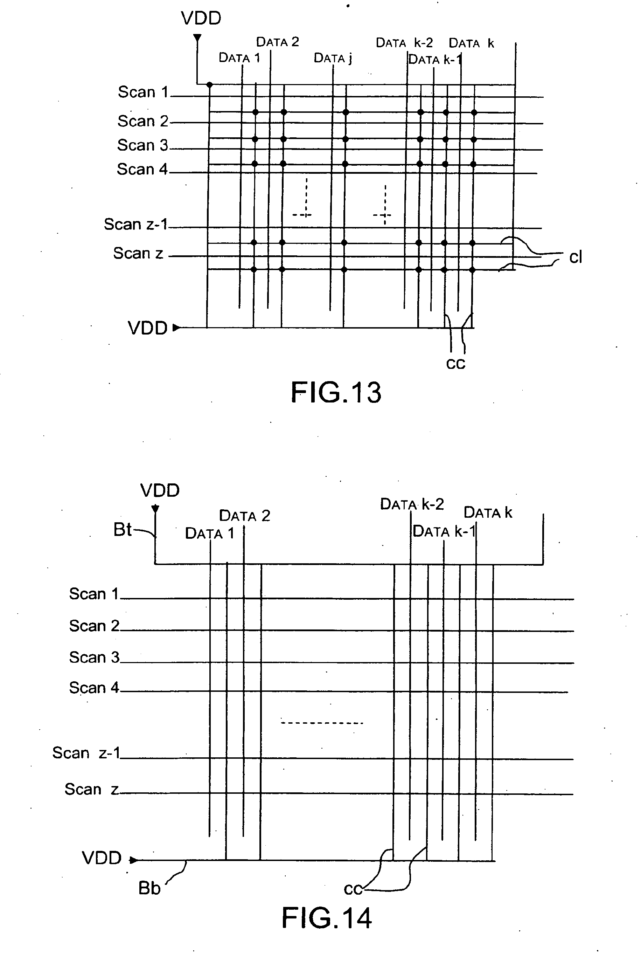

L'alimentation Vdd est avantageusement distribuée sur la matrice non pas seulement en colonne (ou seulement en ligne) mais suivant un maillage de conducteurs lignes/colonnes cl et cc en continuité électrique comme illustré sur la figure 13, qui permet d'amener Vdd sur les électrodes source/drain des transistors de commande en courant T2 et T2', aux noeuds n1 et n2 qui correspondent aussi chacun au noeud commun entre le transistor de commande en courant et le condensateur de maintien du circuit de commande correspondant. Cette distribution de l'alimentation Vdd se fait sans empiéter sur la zone de l'électrode pixel E1 sur laquelle est réalisée la diode Oled. Avec un tel maillage du bus d'alimentation Vdd, la résistance d'accès est faible et sensiblement la même pour tous les points image. Le maillage assure avantageusement une fonction de redondance en sorte que le rendement de fabrication de la matrice est bien meilleur : le maillage permet de garantir la distribution en courant pour tous les points image de la zone active même dans le cas de coupures qui peuvent se produire sur les colonnes ou les lignes d'alimentation dans le processus de fabrication. Le maillage permet d'atteindre tous les noeuds de connexion à Vdd (n1, n2) de la matrice tout en optimisant la zone optique disponible en chaque point image.

Le bus d'alimentation Vdd est typiquement réalisé sur le niveau de métal source-drain Msd de la matrice (typiquement du molybdène (Mo) ). Il réalise ainsi naturellement une électrode source-drain des transistors T2 et T2' en s'étendant latéralement suivant les rangées de part et d'autre de chaque colonne d'alimentation Vdd, formant ainsi le maillage.

Le niveau de métal source-drain est aussi habituellement celui des lignes de données DATA j, DATA j' qui forment ainsi naturellement dans les électrodes source-drain des transistors de commutation T1, T1', par exemple l'électrode e1_{sd} du transistor T1 (figure 5).

Entre deux colonnes de points images, on a ainsi trois conducteurs verticaux : un conducteur colonne d'alimentation Vdd et deux conducteurs colonne de lignes de données disposés par exemple de part et d'autre, DATA j' et DATA j+1.

Pour à la fois limiter les risques de court-circuit sur le niveau métal source-drain entre les conducteurs colonne coplanaires, et réaliser ces différents conducteurs colonne de manière rapprochée de manière à favoriser l'ouverture optique, les lignes de données sont avantageusement réalisées en utilisant un procédé de tricotage entre deux niveaux métal de la matrice : le niveau métal source-drain Msd est utilisé uniquement dans la zone géographique des transistors, pour réaliser des électrodes source/drain e1_{sd} des transistors de commutation T1 et T1'. Le niveau métal de grille Mg est utilisé partout ailleurs, et notamment le long des électrodes pixels E1, ce qui permet d'avoir la colonne d'alimentation Vdd et les lignes de données de part et d'autre très rapprochées. Pour les lignes de données, le passage entre les deux niveaux de métal Msd et Mg se fait typiquement au moyen de points de contacts ct1, ct2, obtenus par une ouverture Oig dans la couche d'isolant de grille, permettant au niveau de métal source-drain Msd de venir contacter en ces points le niveau de métal de grille.

L'autre électrode source-drain e1'_{sd} des transistors de commutation T1, T1' en métal source drain est connectée à la grille du transistor de commande en courant associé T2 ou T'2 en prévoyant une ouverture dans l'isolant de grille pour faire le contact (ct3).

Le maillage du bus d'alimentation Vdd permet de ne pas faire passer un conducteur en métal source drain Msd dans la zone entre les deux points de contacts ct1 et ct2 : le conducteur colonne Vdd en métal source drain Msd se dédouble de part et d'autre en conducteurs ligne d'alimentation avant ct1 pour former de chaque côté les électrodes source-drain e2_{sd} et e2'_{sd} des transistors T2 et T2' qui se font face symétriquement par rapport à la ligne de sélection, et se réunifie de l'autre côté après ct2. En d'autres termes le maillage Vdd est réalisé de manière à détourer chacun des couples de transistors T1 et T1' tête-bêche. De cette façon l'ouverture optique est optimisée sans rien sacrifier à la fiabilité du procédé de fabrication et au rendement de fabrication.

L'électrode pixel E1 est typiquement réalisée sur le niveau de métal source/drain Msd (figure 5). Une ouverture Op est réalisée dans la couche de passivation de la matrice pour dégager une zone de contact sur cette électrode E1, c'est à dire la zone optique du point image sur laquelle viendra se "poser" la diode électroluminescente organique.

Pour optimiser la surface occupée par les transistors de commande en courant, qui doivent avoir un dimensionnement de la largeur W du canal suffisamment important pour fournir le courant nécessaire aux diodes Oled, ces transistors T2, T2' ont avantageusement une topologie dite à électrodes source-drain interdigitées comme illustré sur la figure 5, ce qui permet d'obtenir le rapport désiré dans un minimum de largeur (en considérant la largeur dans le sens des lignes de sélection), et donc sans dégrader le taux d'ouverture optique du point image. Plus précisément, une électrode source-drain e2_{sd} de ces transistors est formée par des excroissances (des doigts) de l'électrode pixel E1 (métal source-drain Msd), tandis que l'autre électrode source-drain e2'_{sd} est formé par des excroissances partant du bus d'alimentation Vdd. Le positionnement symétrique de deux transistors T2 et T2' par rapport à chaque ligne de sélection permet de réaliser une électrode correspondante e2_{sd} dans chacun de ces deux transistors à partir de la même portion de conducteur ligne d'alimentation Vdd. On notera qu'à cet endroit le conducteur d'alimentation Vdd (en métal Msd) est situé sur la ligne de sélection en métal de grille Mg, en sorte que l'on a une gestion optimum de l'espace occupé. En outre cette implémentation avec une pluralité de doigts d'électrodes permet de limiter les problèmes de défectuosité de points images en cas de coupure au niveau d'un doigt, par rapport à des implémentations à doigts uniques.

Entre deux colonnes d'éléments image, on trouve ainsi deux conducteurs colonne de lignes de données, par exemple DATA j' et DATA j+1 encadrant de part et d'autre un conducteur colonne d'alimentation Vdd.

L'arrangement selon l'invention permet notamment d'optimiser la surface occupée par un point image à quatre transistors, avec un taux d'ouverture optique intéressant.

Les transistors sont typiquement des transistors à couche mince TFT, de préférence en silicium amorphe : le canal de ces transistors est réalisé en silicium amorphe aSi, entre les électrodes source-drain (niveau Msd) et commandé par la grille (sur le niveau Mg) comme plus particulièrement mis en évidence sur un des transistors de la figure 5.

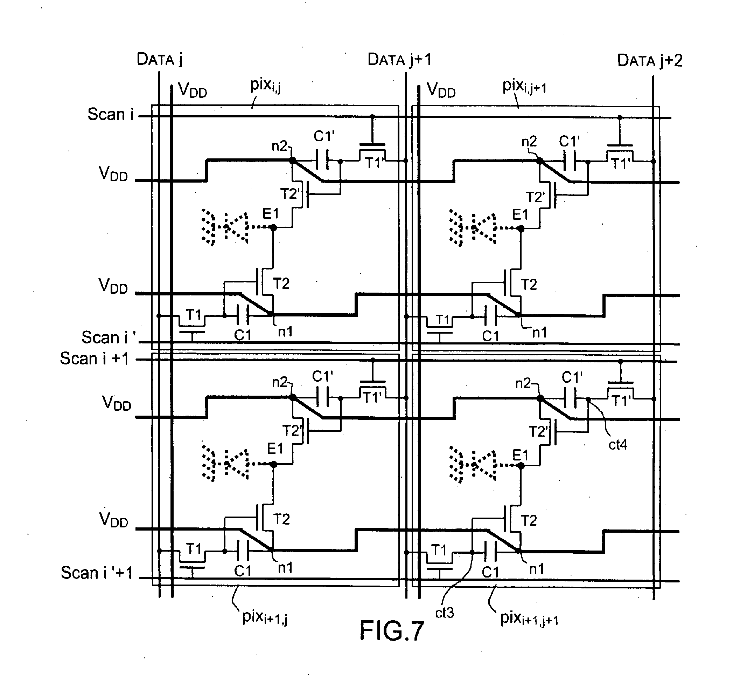

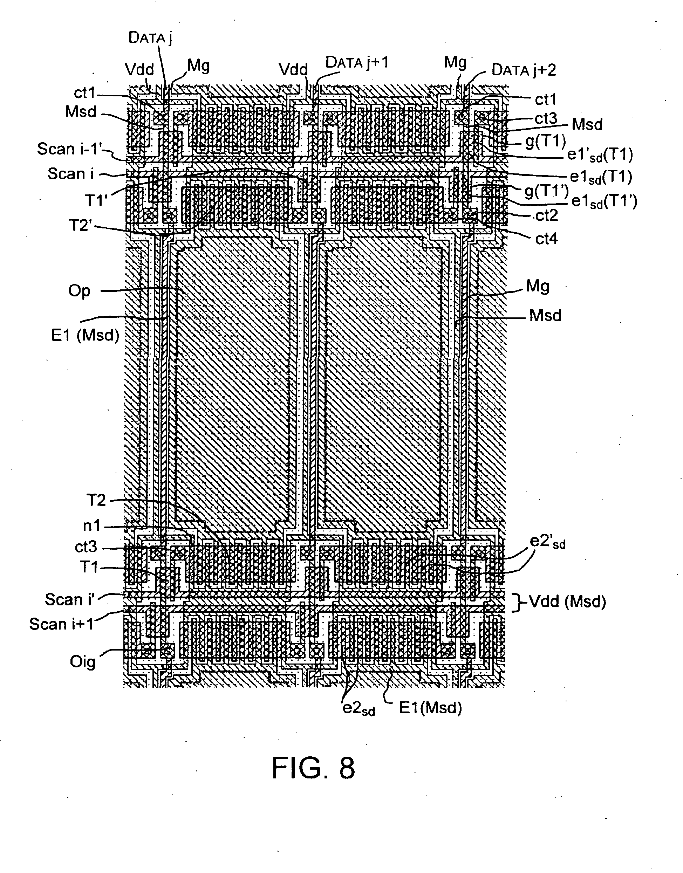

La figure 6 est un schéma électrique de principe qui illustre un autre mode de réalisation de l'adressage des transistors de commutation T1 et T1' d'une structure de commande à quatre transistors, pour commander de manière alternative la fonction d'affichage ou la fonction de récupération sur les circuits de commande associés COM et COM'. La figure 7 est un schéma électrique correspondant à une implémentation d'un point image correspondant selon l'invention et la figure 8 montre une implémentation topologique d'une matrice active correspondante.

Au lieu d'insérer des lignes de données supplémentaires pour permettre l'alternance des fonctions d'affichage et de récupération des circuits de commande COM et COM' comme dans la figure 3, on utilise les lignes de sélection : au lieu de doubler le nombre de lignes de données, on double les lignes de sélection. Une matrice correspondante comprendra alors 2.m lignes de sélection, deux par pixel, et n lignes de données associées aux m.n pixels pix_{i,j} de l'écran.

Dans ce mode de réalisation, la grille du transistor de commutation T1 est connectée à la ligne de sélection Scan i du pixel pix_{i,j}, et la grille du transistor de commutation dual T1' est connectée à une autre ligne de sélection que l'on note Scan i'. Comme illustré sur la figure 8, la même ligne de données, par exemple Data j+2, est connectée à une électrode source-drain e1_{sd} de tous les transistors T1 des points image de la colonne à droite de cette ligne et à une électrode source-drain e1'_{Sd} de tous les transistors T1' des points image de la colonne à gauche de cette ligne.

Sur le plan de l'arrangement et de la topologie de la matrice, tout ce qui a été décrit précédemment en relation avec les figures 3 à 6 s'applique de la même manière, puisque dans les deux cas chaque point image est encadré par deux lignes de sélection qui commandent chacune un des transistors de commutation (T1, T1') de ce point image. Mais l'espace nécessaire pour la réalisation des points image est plus intéressant ici, car on a seulement un conducteur d'alimentation et une ligne de données entre deux colonnes de points image.

En outre le positionnement tête-bêche des deux transistors T1 et T1' associés à la même ligne de données et à la même ligne de sélection permet alors de réaliser l'électrode source drain e1_{sd} de ces deux transistors T1 et T1' avec le même conducteur de ligne de donnée, c'est à dire la partie de métal source-drain Msd entre les deux contacts ct1 et ct2, sans avoir à en adapter le dessin. L'espace est ainsi optimisé au mieux.

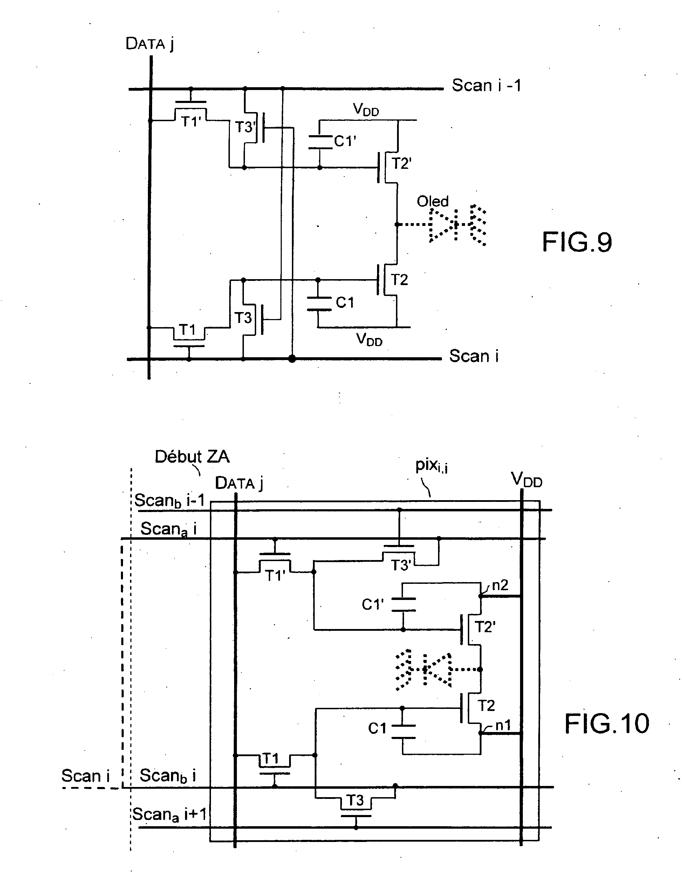

La figure 9 illustre un schéma de principe d'un point image Oled avec une structure de commande à six transistors, trois par circuit de commande COM. L'intérêt d'une telle structure est de ne pas nécessiter de lignes de sélection ou de données supplémentaires pour commander les fonctions d'affichage vidéo et de récupération en alternance sur les circuits de commande COM et COM'. On a donc pour un écran de n.m points images, m lignes de sélection Scan i et n lignes de données DATA j comme dans l'état de l'art (Figure 1).

Ceci est un avantage précieux en termes de topologie de circuit (croisement de lignes, commande des lignes) et d'espace occupé. Ceci est obtenu en prévoyant un transistor de commutation supplémentaire par lequel on va assurer la commande alternée des transistors de commande en courant. On note T3 pour le circuit COM et T3' pour le circuit COM' ce transistor de commutation supplémentaire du circuit de commande. Dans la suite on désigne par premier transistor de commutation les transistors T1 et T1' et par deuxième transistor de commutation les transistors T3 et T3'.

Comme illustré sur les figures 8 et 9, pour chaque point image pix_{i,j} on a une seule ligne de donnée DATA j qui est connectée aux premiers transistors de commutation T1 et T1' des deux circuits de commande COM et COM', une première ligne de sélection à laquelle est connectée la grille du premier transistor de commutation de l'un des circuits de commande et une autre ligne de sélection de la matrice, de préférence la ligne précédente, à laquelle est connectée la grille du premier transistor de commutation de l'autre circuit de commande. Dans l'exemple, pour le point image pix_{i,j}, la ligne de sélection Scan i est connectée à la grille du transistor de commutation T1 du circuit COM, la ligne de sélection Scan i-1 est connectée à la grille du transistor de commutation T1' du circuit COM'. Les éléments T1, C1 et T2 du circuit COM et T1', C1' et T2' du circuit COM' sont par ailleurs connectés entre eux et à la diode Oled comme indiqué précédemment notamment en relation avec la figure 3. On note comme précédemment : n1, respectivement n2, le noeud de connexion à Vdd d'une électrode source-drain du transistor, T2, respectivement T2' ; et ct3, respectivement ct4, le noeud de connexion d'une électrode source-drain du premier transistor de commutation T1, respectivement T1' à la grille du transistor de commande T2, respectivement T2'.

Le deuxième transistor de commutation T3, T3' prévu dans chaque circuit de commande, est connecté entre la grille du transistor de commande en courant et la ligne de sélection Scan i respectivement Scan i-1 du premier transistor de commutation du circuit de commande auquel il appartient. La grille du deuxième transistor de commutation d'un circuit de commande est connectée à la ligne de sélection associée à l'autre circuit de commande. Dans l'exemple illustré, le transistor T3 du point image pix_{i,j} est ainsi connecté entre la ligne de sélection Scan i du transistor de commutation T1 et la grille du transistor de commande en courant T2. Et sa grille est connectée à la ligne de sélection Scan i-1. Le transistor T3' est connecté entre la ligne de sélection Scan i-1 du transistor de commutation T1' et la grille du transistor de commande en courant T2'. Et sa grille est connectée à la ligne de sélection Scan i.

Selon l'invention, un arrangement du point image correspondant est prévu de manière à optimiser l'espace au mieux, tout en tenant compte des contraintes technologiques. Notamment, comme déjà indiqué précédemment, on cherche à disposer les circuits de commande COM et COM' de manière symétrique au sein du point image de manière à obtenir un taux d'ouverture optique optimal. Il est particulièrement avantageux de pouvoir disposer les transistors de commutation de manière tête-bêche, permettant de limiter l'espace nécessaire et de faciliter les connexions. Il est également avantageux de pouvoir disposer les transistors de commande en courant de manière symétrique relativement aux lignes de sélection.

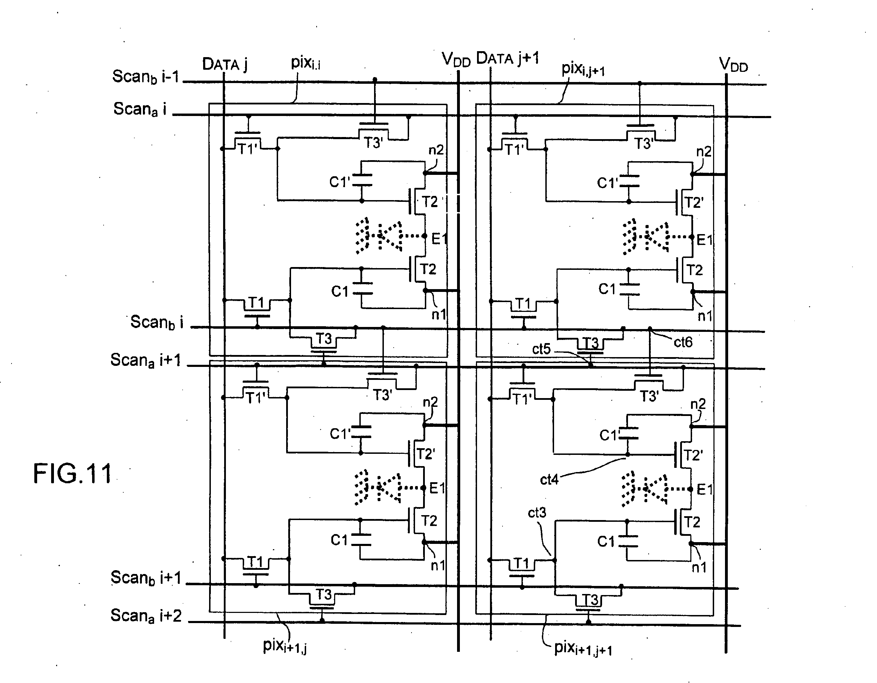

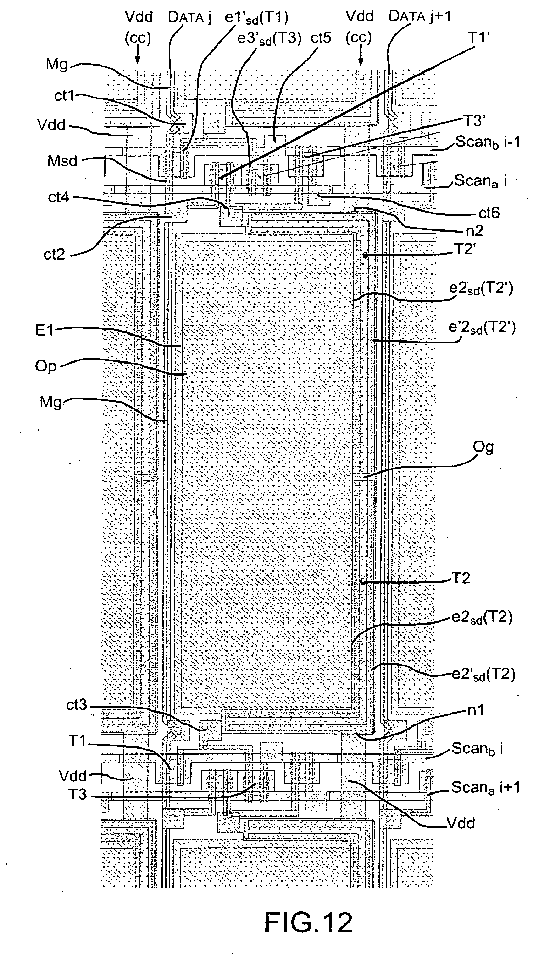

Un arrangement correspondant suivant l'invention est illustré sur les figures 10, 11 et 12. Les figures 10 et 11 sont des schémas électriques d'un point image (figure 10) et de quatre points images adjacents (figure 11). La figure 12 est un schéma topologique d'une matrice correspondante.

Dans cet arrangement, un dédoublement des lignes de sélection est prévu en sorte que l'on ait deux branches Scanₐ i et Scan_{b} i d'une ligne de sélection Scan i de part et d'autre de la zone optique. Chaque point image est ainsi encadré par deux lignes de sélection qui sont les branches haute Scanₐ i et basse Scan_{b} i de la même ligne de sélection. Cet arrangement permet une implémentation favorable des transistors de commutation du point image sans croisement au travers du point image. Il permet aussi une disposition symétrique des deux circuits de commande COM et COM' du point image, de part et d'autre de l'électrode pixel E1. En pratique le dédoublement des lignes est prévu en limite de zone active ZA.

Les transistors de commande T2 et T2' en courant d'un pixel sont disposés le long de l'électrode pixel, entre l'électrode pixel E1, qui forme une électrode source-drain e2_{sd} de ces transistors et une colonne d'alimentation Vdd, qui en forme l'autre électrode e2'_{sd}. On a ici des transistors en L, à un seul doigt d'électrodes source-drain. La largeur W du canal qui doit être importante pour ces transistors est ici obtenue en exploitant la longueur de l'électrode pixel E1. La séparation entre les deux transistors T2 et T2' est obtenue par une séparation Og entre les deux grilles g de ces transistors.

Le bus d'alimentation Vdd est distribué par des conducteurs colonnes d'alimentation cc issus d'un bus principal haut Bt ou bas Bb comme illustré sur la figure 14. On a ainsi un conducteur colonne d'alimentation cc pour chaque colonne de points image, disposé dans chaque intervalle entre deux colonnes de points image (figure 12). En effet, un maillage comme sur la figure 13 n'est pas avantageux dans le cas de la structure de commande à six transistors. Pour limiter la chute de tension dans les conducteurs colonnes d'alimentation cc du fait de la consommation de courant dans les points d'image, on réalise de larges conducteurs colonnes d'alimentation comme on peut le voir sur la figure 12, de manière à obtenir une résistance d'accès la plus faible possible.

En dehors de ces différences, liées à la présence d'un transistor de commutation supplémentaire par circuit de commande, les autres particularités d'un arrangement selon l'invention vues en relation avec les modes de réalisation précédents pour des structures de commande à quatre transistors s'appliquent à l'identique avec les même effets. On retrouve notamment le tricotage avec les points de contacts ct1 et ct2. Les transistors de commutation sont concentrés entre deux lignes de sélection successives, à savoir entre la branche basse d'une ligne de sélection, par exemple Scan_{b} i et la branche haute de la ligne de sélection suivante, dans l'exemple Scanₐ i+1. Cette disposition permet d'optimiser les différentes connexions à réaliser, notamment les connexions reliant en commun les électrodes source-drain des transistors de commutation d'un circuit de commande à la grille du transistor de commande en courant : on a ainsi un point de contact ct3 pour connecter l'électrode source-drain e'1_{sd} du transistors T1 et l'électrode source-drain e'3_{sd} du transistors T3, à la grille du transistor T2 ; un point de contact ct4 pour connecter l'électrode source-drain e'1_{sd} du transistors T1' et l'électrode source-drain e'3_{sd} du transistors T3', à la grille du transistor T2'.

Les points de contact ct1 et ct2 servent en outre à connecter l'électrode source-drain e1 sd du transistor T1' à la ligne de donnée associée au point image correspondant, qui forme l'électrode source-drain e1_{sd} du transistor T1 du point image précédent dans la colonne.

Un point de contact ct5, respectivement ct6 permet de connecter l'électrode e3_{sd} du transistor T3, respectivement T3', à la ligne de sélection correspondante.

Les différents exemples d'arrangements qui viennent d'être donnés pour illustrer l'invention, montrent qu'en arrangeant chaque point image entre deux lignes de sélection qui pilotent les transistors de commutation de ce point image (dans le premier exemple, Scan i et Scan i' dans le deuxième exemple, Scanₐ i et Scan_{b} i), il est possible de disposer les deux circuits de commande de façon symétrique, de part et d'autre de l'électrode pixel, entre l'électrode pixel et la ligne de sélection qui pilote le ou les transistors de commutation du circuit de commande concerné, et un tricotage des lignes de données entre le niveau conducteur des électrodes source-drain des transistors et le niveau conducteur de grille des transistors permet de réaliser une matrice active avec une ouverture optique maximale et une fiabilité de fabrication optimale (pas de risques de courts-circuits liés à des excès de métaux entre des conducteurs coplanaires).

L'arrangement tête-bêche des transistors de commutation pilotées par la même ligne de sélection favorise avantageusement l'ouverture optique.

Dans les exemples illustrés, les condensateurs de maintien C1 et C1' sont typiquement réalisés par les capacités grille-source (ou grille-drain) des transistors de commande en courant.

Le maillage du bus d'alimentation (figure 13) qui peut être avantageusement mis en oeuvre dans le cas où les circuits de commande comprennent un unique transistor de commutation , permet d'améliorer la résistance d'accès et donc d'obtenir une meilleure distribution énergétique sur la matrice, tout en améliorant la fiabilité du procédé de fabrication (redondance).

L'invention qui vient d'être décrite s'applique tout particulièrement aux écrans électroluminescents organiques, qui utilisent une matrice active à transistors TFT (silicium amorphe). Elle s'applique de manière plus générale aux écrans électroluminescents organiques à matrice active.

## Revendications

1. Matrice active pour un écran électroluminescent organique, comprenant des points images (pix_{i,j}) arrangés en lignes et en colonnes, et des lignes de sélection et des lignes de données pour commander lesdits points image telles que chaque point image est disposé entre deux lignes de sélection de la matrice et chaque ligne de donnée est disposée entre deux colonnes de points image de la matrice, chaque point image comprenant une électrode pixel (E1) apte à recevoir une diode électroluminescente organique (Oled) en surface, et un premier et un deuxième circuits de commande en courant (COM,COM') connectés à ladite électrode pixel (E1), avec une structure identique comprenant un transistor de commande en courant (T2, T2') connecté entre une tension d'alimentation Vdd et ladite électrode pixel (E1) et au moins un premier transistor de commutation (T1, T1') pour commander la grille dudit transistor de commande en courant, ledit premier transistor de commutation étant connecté entre une ligne de donnée (D_{ATA} j) de la matrice et la grille dudit transistor de commande en courant (T2), et ayant sa grille connectée à une ligne de sélection (Scan i) de la matrice, les électrodes de source ou drain des transistors de commutation et de commande et les électrodes pixel étant réalisées sur un niveau métal source drain (Msd), et les électrodes de grille de ces transistors étant chacune réalisées par une ligne de sélection de la matrice, sur un niveau métal de grille (Mg), **caractérisé en ce que**
• pour chaque point image, un circuit de commande (COM) est disposé entre une première (Scan i) de ces deux lignes de sélection et son électrode pixel (E1), ladite première ligne de sélection formant la grille du premier transistor de commutation (T1) de ce circuit de commande (COM), et l'autre circuit de commande est disposé entre une deuxième (Scan i+1) de ces deux lignes de sélection et l'électrode pixel, ladite deuxième ligne de sélection formant la grille du premier transistor de commutation (T1') de ce circuit de commande (COM'),
• une électrode source drain (e2'_{sd}) des transistors de commande (T2, T2') est formée par un bus d'alimentation Vdd réalisé sur le niveau métal source drain, et l'autre électrode source drain (e2_{sd}) des transistors de commande est formé par au moins un doigt qui est une excroissance de l'électrode pixel (E1) sur le même niveau métal source drain;
• chaque ligne de données est formée en utilisant ledit niveau de métal source-drain (Msd) et ledit niveau métal de grille (Mg), ledit niveau de métal de grille étant utilisé le long des électrodes pixel (E1) et ledit niveau de métal source drain étant utilisé dans les zones entre lesdites électrodes pixel où sont réalisés les transistors de commutation desdits circuits de commande.

2. Matrice selon la revendication 1, dans laquelle ladite tension d'alimentation Vdd est distribuée sur la matrice au moyen d'un bus d'alimentation avec un maillage ligne/colonne.

3. Matrice selon la revendication 2, dans laquelle chaque intervalle entre deux colonnes successives de points image, comprend un conducteur colonne de bus d'alimentation Vdd et au moins un conducteur colonne de ligne de donnée (Data j).

4. Matrice selon la revendication 2 ou 3, dans laquelle le premier transistor de commutation (T1) du premier circuit de commutation (COM) d'un point image et le premier transistor de commutation (T1') d'un deuxième circuit de commutation (COM') d'un autre point image, sont disposés tête-bêche de part et d'autre d'une ligne de sélection (Scan i).

5. Matrice selon la revendication 4, dans laquelle chaque intervalle entre deux colonnes successives de points image, comprend un conducteur colonne de bus d'alimentation Vdd et un conducteur colonne de ligne de donnée (Data j), et lesdits premiers transistors de commutation disposés tête-bêche ont une électrode de source drain (e1_{sd}) formée par une portion de conducteur colonne en métal source drain de la même ligne de donnée (Data j+1).

6. Matrice selon la revendication 2 ou 3, dans laquelle le transistor de commande (T2) du premier circuit de commutation (COM) d'un point image dans une colonne et le transistor de commande (T2') du deuxième circuit de commutation (COM') d'un point image précédent ou suivant dans la même colonne, sont disposés de façon symétrique de part et d'autre d'une ligne de sélection (Scan i).

7. Matrice selon la revendication 2 ou 3, dans laquelle les transistors de commande desdits premier et deuxième circuit de commande sont à électrodes source-drain interdigitées, chaque électrode source drain comportant plus d'un doigt.

8. Matrice selon la revendication 1, dont la structure des dits premiers circuits (COM), et deuxièmes circuits (COM') comprend en outre un deuxième transistor de commutation (T3) connecté entre la ligne de sélection (Scan i) à laquelle est connectée la grille du premier transistor de commutation (T1) du circuit de commande considéré (COM), et la grille dudit transistor de commande (T2) et dont la grille est connectée à une autre ligne de sélection (Scan i+1), **caractérisée en ce que** chaque ligne de sélection est dédoublée dans la zone active (ZA) en une première branche (Scan_{b} i) et une deuxième branche (Scan_{b} i) disposées de part et d'autre d'une rangée correspondante de points image (pix_{i,j}).

9. Matrice selon la revendication 8, dans laquelle la tension d'alimentation est distribuée par des conducteurs colonnes, avec un conducteur colonne d'alimentation Vdd dans chaque intervalle entre deux colonnes de points image, et dans laquelle les transistors de commande (T2, T2') des premier et deuxième circuits de commande d'un point image sont réalisés le long de l'électrode pixel, entre ladite électrode pixel (E1) et ledit conducteur colonne d'alimentation Vdd qui forment respectivement une première (e2_{sd}) et une deuxième électrode source drain (e2'_{sd}) des dits transistors de commande (T2, T2').

10. Ecran à diodes organiques électroluminescentes comprenant une matrice active selon l'une quelconque des revendications précédentes.

## Claims

1. Active matrix for an organic electroluminescent screen comprising image points (pix_{i,j}) which are arranged in rows and in columns, and selection rows and data rows in order to control the image points so that each image point is arranged between two selection rows of the matrix and each data row is arranged between two image point columns of the matrix, each image point comprising a pixel electrode (E1) which is capable of receiving an organic electroluminescent diode (Oled) at the surface, and a first and a second current control circuit (COM, COM') which are connected to the pixel electrode (E1), with an identical structure which comprises a current control transistor (T2, T2') connected between a supply voltage Vdd and the pixel electrode (E1) and at least a first commutation transistor (T1, T1') for controlling the grid of the current control transistor, the first commutation transistor being connected between a data row (DATA j) of the matrix and the grid of the current control transistor (T2), and having the grid thereof connected to a selection row (Scan i) of the matrix, the source or drain electrodes of the commutation and control transistors and the pixel electrodes being produced on a metal source/drain level (Msd) and the grid electrodes of these transistors each being produced by a selection row of the matrix, on a metal grid level (Mg), **characterised in that**
• for each image point, a control circuit (COM) is arranged between a first (Scan i) of these two selection rows and the pixel electrode (E1) thereof, the first selection row forming the grid of the first commutation transistor (T1) of this control circuit (COM), and the other control circuit is arranged between a second (Scan i+1) of these two selection rows and the pixel electrode, the second selection row forming the grid of the first commutation transistor (T1') of this control circuit (COM'),
• a source/drain electrode (e2'_{sd}) of the control transistors (T2, T2') is formed by a supply bus Vdd which is produced on the metal source/drain level, and the other source/drain electrode (e2_{sd}) of the control transistors is formed by at least one member which is a protuberance of the pixel electrode (E1) on the same metal source/drain level;
• each data row is formed by using the metal source/drain level (Msd) and the metal grid level (Mg), the metal grid level being used along the pixel electrodes (E1) and the metal source/drain level being used in the zones between the pixel electrodes in which the commutation transistors of the control circuits are produced.

2. Matrix according to claim 1, wherein the supply voltage Vdd is distributed over the matrix using a supply bus with a row/column mesh.

3. Matrix according to claim 2, wherein each gap between two successive image point columns comprises a supply bus column conductor Vdd and at least one data row column conductor (Data j).

4. Matrix according to claim 2 or claim 3, wherein the first commutation transistor (T1) of the first commutation circuit (COM) of an image point and the first commutation transistor (T1') of a second commutation circuit (COM') of another image point are arranged head to tail at one side and the other of a selection row (Scan i).

5. Matrix according to claim 4, wherein each gap between two successive image point columns comprises a supply bus column conductor Vdd and a data row column conductor (Data j), and the first commutation transistors arranged head to tail have a source/drain electrode (e1_{sd}) formed by a source/drain metal conductor column portion of the same data row (Data j+1).

6. Matrix according to claim 2 or claim 3, wherein the control transistor (T2) of the first commutation circuit (COM) of an image point in a column and the control transistor (T2') of the second commutation circuit (COM') of a preceding or following image point in the same column are arranged in a symmetrical manner at one side and the other of a selection row (Scan i).

7. Matrix according to claim 2 or claim 3, wherein the control transistors of the first and second control circuits are of the type having interdigitised source/drain electrodes, each source/drain electrode comprising more than one member.

8. Matrix according to claim 1, whose structure of the first circuits (COM) and second circuits (COM') further comprises a second commutation transistor (T3) which is connected between the selection row (Scan i) to which the grid of the first commutation transistor (T1) of the control circuit (COM) in question is connected, and the grid of the control transistor (T2) and whose grid is connected to another selection row (Scan i+1), **characterised in that** each selection row is split in the active zone (ZA) into a first branch (Scan_{b} i) and a second branch (Scan_{b} i) arranged at one side and the other of a corresponding row of image points (pix_{i,j}).

9. Matrix according to claim 8, wherein the supply voltage is distributed by column conductors, with a supply column conductor Vdd in each gap between two image point columns, and wherein the control transistors (T2, T2') of the first and second control circuits of an image point are produced along the pixel electrode, between the pixel electrode (E1) and the supply column conductor Vdd which form a first source/drain electrode (e2_{sd}) and a second source/drain electrode (e2'_{sd}) of the control transistors (T2, T2').

10. Electroluminescent organic diode screen comprising an active matrix according to any one of the preceding claims.

## Patentansprüche

1. Aktive Matrix für einen elektrolumineszenten organischen Bildschirm, die in Reihen und Spalten angeordnete Bildpunkte (pix_{i,j}) sowie Auswahlleitungen und Datenleitungen zum Steuern der Bildpunkte beinhaltet, so dass jeder Bildpunkt zwischen zwei Auswahlleitungen der Matrix angeordnet ist und jede Datenleitung zwischen zwei Bildpunktspalten der Matrix angeordnet ist, wobei jeder Bildpunkt ein Elektrodenpixel (E1) zum Aufnehmen einer elektrolumineszenten organischen Oberflächendiode (Oled) sowie einen ersten und einen zweiten mit dem Elektrodenpixel (E1) verbundenen Steuerstromkreis (COM, COM') mit einer identischen Struktur mit einem Stromsteuertransistor (T2, T2'), der zwischen einer Speisespannung Vdd und dem Elektrodenpixel (E1) geschaltet ist, und wenigstens einem ersten Schalttransistor (T1, T1') zum Steuern des Gatters des Stromsteuertransistors umfasst, wobei der erste Schalttransistor zwischen einer Datenleitung (DATA j) der Matrix und dem Gatter des Stromsteuertransistors (T2) geschaltet und sein Gatter mit einer Auswahlleitung (Scan i) der Matrix verbunden ist, wobei die Source- oder Drain-Elektroden der Schalt- und Steuertransistoren und die Pixelelektroden auf einem Source-Drain-Metallpegel (Msd) und die Gatterelektroden dieser Transistoren jeweils durch eine Auswahlleitung der Matrix auf einem Gattermetallpegel (Mg) realisiert werden, **dadurch gekennzeichnet, dass**
• für jeden Bildpunkt ein Steuerstromkreis (COM) zwischen einer ersten (Scan i) dieser beiden Auswahlleitungen und dem Elektrodenpixel (E1) angeordnet ist, wobei die erste Auswahlleitung das Gatter des ersten Schalttransistors (T1) dieses Steuerstromkreises (COM) bildet und der andere Steuerstromkreis zwischen einer zweiten (Scan i+1) dieser beiden Auswahlleitungen und der Pixelelektrode angeordnet ist, wobei die zweite Auswahlleitung das Gatter des ersten Schalttransistors (T1') dieses Steuerstromkreises (COM') bildet,
• eine Source-Drain-Elektrode (e2'_{sd}) der Schalttransistoren (T2, T2') durch einen Versorgungsbus Vdd auf dem Source-Drain-Metallpegel gebildet wird und die andere Source-Drain-Elektrode (e2_{sd}) der Schalttransistoren durch wenigstens einen Finger gebildet wird, der ein Auswuchs des Elektrodenpixels (E1) auf demselben Source-Drain-Metallpegel ist;
• jede Datenleitung mit dem Source-Drain-Metallpegel (Msd) und dem Gattermetallpegel (Mg) gebildet wird, wobei der Gattermetallpegel entlang den Pixelelektroden (E1) verwendet wird und wobei der Source-Drain-Metallpegel in den Zonen zwischen den Pixelelektroden verwendet wird, wo die Schalttransistoren der Steuerstromkreise realisiert sind.

2. Matrix nach Anspruch 1, bei der die Speisespannung Vdd mittels eines Versorgungsbusses mit einem Netz von Reihen und Spalten auf der Matrix verteilt wird.

3. Matrix nach Anspruch 2, in der jedes Intervall zwischen zwei aufeinander folgenden Bildpunktspalten eine Versorgungsbus-Leiterspalte Vdd und wenigstens eine Datenleitung-Leiterspalte (Data j) umfasst.

4. Matrix nach Anspruch 2 oder 3, in der der erste Schalttransistor (T1) des ersten Schaltstromkreises (COM) eines Bildpunktes und der erste Schalttransistor (T1') eines zweiten Schaltstromkreises (COM') eines anderen Bildpunktes auf beiden Seiten einer Auswahlleitung (Scan i) umgekehrt angeordnet sind.

5. Matrix nach Anspruch 4, bei der jedes Intervall zwischen zwei aufeinander folgenden Spalten von Bildpunkten eine Versorgungsbus-Leiterspalte Vdd und eine Datenleitung-Leiterspalte (Data j) umfasst und die ersten umgekehrt angeordneten Schalttransistoren eine von einem Spaltenleiterabschnitt aus Source-Drain-Metall derselben Datenleitung (Dataj+1) gebildete Source-Drain-Elektrode (e1_{sd}) haben.

6. Matrix nach Anspruch 2 oder 3, bei der der Steuertransistor (T2) des ersten Schaltstromkreises (COM) eines Bildpunktes in einer Spalte und der Steuertransistor (T2') des zweiten Schaltstromkreises (COM') eines Bildpunktes davor oder dahinter in derselben Spalte auf beiden Seiten einer Auswahlleitung (Scan i) symmetrisch angeordnet sind.

7. Matrix nach Anspruch 2 oder 3, bei der die Steuertransistoren des ersten und zweiten Steuerstromkreises ineinander greifende Source-Drain-Elektroden sind, wobei jede Source-Drain-Elektrode mehr als einen Finger aufweist.

8. Matrix nach Anspruch 1, bei der die Struktur der ersten Stromkreise (COM) und der zweiten Stromkreise (COM') darüber hinaus einen zweiten Schalttransistor (T3) umfasst, der zwischen der Auswahlleitung (Scan i), mit der das Gatter des ersten Schalttransistors (T1) des betrachteten Steuerstromkreises (COM) verbunden ist, und dem Gatter des Steuertransistors (T2) geschaltet ist, und bei der das Gatter mit einer anderen Auswahlleitung (Scan i+1) verbunden ist, **dadurch gekennzeichnet, dass** jede Auswahlleitung in der aktiven Zone (ZA) in einen ersten Zweig (Scan_{b} i) und einen zweiten Zweig (Scan_{b} i) unterteilt ist, die auf beiden Seiten einer entsprechenden Zeile von Bildpunkten (pix_{i,j}) angeordnet sind.

9. Matrix nach Anspruch 8, bei der die Speisespannung durch die Spaltenleiter verteilt wird, mit einem Versorgungsspaltenleiter Vdd in jedem Intervall zwischen zwei Bildpunktspalten, und wobei die Steuertransistoren (T2, T2') des ersten und zweiten Steuerstromkreises von einem Bildpunkt entlang der Pixelelektrode realisiert werden, zwischen der Pixelelektrode (E1) und dem Versorgungsspaltenleiter Vdd, die jeweils eine erste (e2_{sd}) und eine zweite (e2'_{sd}) Source-Drain-Elektrode der Steuertransistoren (T2, T2') bilden.

10. Bildschirm mit elektrolumineszenten organischen Dioden, der eine aktive Matrix nach einem der vorherigen Ansprüche umfasst.
